(19) Europäisches Patentamt
European Patent Office
Office européen des brevets

(11) EP 1 897 965 B1

(12) FASCICULE DE BREVET EUROPEEN

(45) Date de publication et mention
de la délivrance du brevet:
01.07.2009 Bulletin 2009/27

(51) Int Cl.:
C22F 1/16 (2006.01)          C30B 33/02 (2006.01)
C30B 29/48 (2006.01)          H01L 21/477 (2006.01)

(21) Numéro de dépôt: 07115691.3

(22) Date de dépôt: 05.09.2007

(54) **Procédé d'élimination par recuit des précipités dans un matériau semi-conducteur II-VI**

Verfahren zum Beseitigen von Ausscheidungen aus einem II-VI Halbleitermaterial durch Glühen.

A process for eliminating precipitates from a semiconductor II-VI material by annealing.

(84) Etats contractants désignés:
AT BE BG CH CY CZ DE DK EE ES FI FR GB GR
HU IE IS IT LI LT LU LV MC MT NL PL PT RO SE
SI SK TR

(30) Priorité: 07.09.2006 FR 0653612

(43) Date de publication de la demande:
12.03.2008 Bulletin 2008/11

(73) Titulaire: COMMISSARIAT A L'ENERGIE
ATOMIQUE
75015 Paris (FR)

(72) Inventeur: Pelliciari, Bernard
38120, Saint Egreve (FR)

(74) Mandataire: Poulin, Gérard et al
Brevatome
3, rue du Docteur Lancereaux
75008 Paris (FR)

(56) Documents cités:
EP-A- 0 423 463          US-A- 4 190 486
US-A- 4 481 044          US-A- 5 201 985

• VYDYANATH H R: "RECIPE TO MINIMIZE TE PRECIPITATION IN CDTE AND (CD,ZN)TE CRYSTALS" JOURNAL OF VACUUM SCIENCE AND TECHNOLOGY: PART B, AVS / AIP, MELVILLE, NEW YORK, NY, US, vol. 10, no. 4, 1 juillet 1992 (1992-07-01), pages 1476-1484, XP000296494 ISSN: 1071-1023
• GREENBERG ET AL: "P-T-X phase equilibrium and vapor pressure scanning of non-stoichiometry in the Cd-Zn-Te system" PROGRESS IN CRYSTAL GROWTH AND CHARACTERIZATION OF MATERIALS, ELSEVIER PUBLISHING, BARKING, GB, vol. 47, no. 2-3, 2003, pages 196-238, XP005010295 ISSN: 0960-8974

## Description

L'invention a trait à un procédé pour éliminer par recuit les précipités dans un matériau semi-conducteur II-VI à sublimation congruente, tel que le CdTe, le CdZnTe ou le ZnTe.

Lesdits précipités sont généralement constitués par l'un des éléments, à savoir l'élément II, tel que le Cd ou l'élément VI, tel que le Te.

Le domaine technique de l'invention peut être défini comme celui de la préparation de matériaux semi-conducteurs et de leur purification, c'est-à-dire l'élimination des défauts et impuretés de ces matériaux.

On s'intéresse plus particulièrement, dans la présente, à la préparation et à sa purification des matériaux semi-conducteurs II-VI à sublimation congruente.

Une question essentielle qui se pose lors de la préparation, par croissance cristalline de matériaux semi-conducteurs II-VI est de faire croître, à partir de la phase liquide, des lingots exempts de défauts, tels que des précipités de l'un des éléments constitutifs de la matrice (élément II ou élément VI), ou, à tout le moins, de réduire le taux de ces défauts.

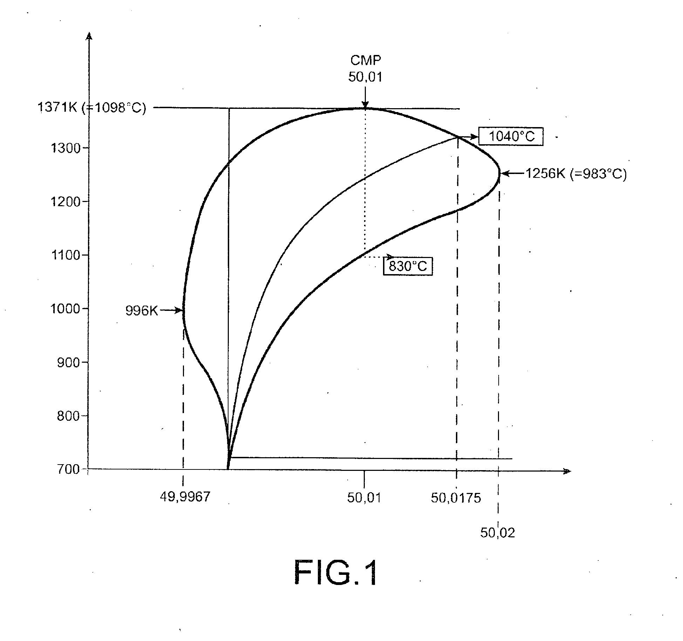

L'origine de ces précipités s'explique thermodynamiquement par l'aspect rétrograde du solidus, immanquablement suivi au cours du refroidissement, comme cela ressort clairement de la figure 1.

Par exemple :

> 1. pour des lingots de CdTe réalisés en tube scellé, au voisinage du point de fusion congruente ($x\ell = 0,50010$), on voit sur le diagramme joint de la figure 1 que les précipités apparaissent à partir du moment où l'on intercepte le solidus, c'est-à-dire aux environs de 830°C ;
>
> 2. pour des lingots de CdTe réalisés en tube scellé, en solvant Tellure $(x_\ell^* > 0,50020)$ par des procédés comme le procédé BRIDGMAN, le procédé BRIDGMAN haute pression, ou le procédé THM, les précipités de Tellure apparaissent dès le refroidissement du premier cristal puisque le point figuratif de ce premier cristal est sur le solidus rétrograde.

Ces précipités de Tellure, de densité et de taille dépendant de la cinétique de refroidissement, sont considérés comme des sources potentielles de défauts particulièrement gênants au cours d'étapes technologiques ultérieures, comme la croissance de couches épitaxiales, la réalisation de diodes p-n, la fabrication de détecteurs X et y, et la fabrication de composants électrooptiques.

Pour faire disparaître les précipités d'un matériau qui en contient, il est connu de recuire ce matériau pour l'amener dans son domaine d'existence, le domaine d'existence étant le domaine compris à l'intérieur de son solidus. La condition à respecter lors de ce traitement de recuit est de ne pas faire franchir au matériau sa courbe de solidus lors du refroidissement.

Ainsi, dans le cas des semi-conducteurs II-VI, afin d'éliminer les précipités d'un lingot qui, du fait de sa métallurgie réalisée préférentiellement en phase liquide à partir de solutions riches en éléments VI, ne peut qu'en posséder, il est possible de mettre en oeuvre un procédé consistant à recuire ce lingot entier, ou chacune des tranches extraites de ce lingot, à remonter le lingot à une température T, dans un tube scellé, et à le soumettre, à cette température, à une pression de l'élément II supérieure à la pression partielle de cet élément II au-dessus du matériau II-VI considéré et élaboré côté élément VI (cette pression devant rester toutefois inférieure à la pression partielle de l'élément II au-dessus du matériau II-VI élaboré côté élément II) : voir la référence [1].

Ainsi, en fonction de la pression de l'élément II appliquée, la composition de ce matériau peut être ajustée à n'importe quelle valeur comprise dans le domaine d'existence à cette température. Dans le cas où la ligne de composition stoechiométrique est incluse dans le domaine d'existence du solide, la composition stoechiométrique peut être atteinte, ainsi que les compositions solides au-delà de la composition stoechiométrique, auquel cas un changement du type de conductivité est généralement observé.

Il apparaît clairement que des lingots ramenés à la composition stoechiométrique peuvent être refroidis sans jamais franchir le solidus, c'est-à-dire sans jamais générer de précipités.

On trouve dans la littérature beaucoup d'articles et de brevets consacrés au recuit de matériaux II-VI, comme CdTe, ou CdZnTe, et ZnTe selon ce procédé : [1], [2], [3], [4].

> [1] US 6,299,680
> [2] H.R. Vydyanath, J.A. Ellsworth, J.B. Parkinson, « Thermomigration of Te Precipitates and Improvement of (Cd, Zn)Te Substrate Characteristics for the Fabrication of LWIR (Hg,CD)Te Photodiodes", Journal of Electronics Materials, vol. 22, n°8, 1993
> [3] Li Yujie and Jie Wanqi, "Reduction of Te-rich phases in Cd1-xZnxTe (x=0.04) crystals", J. Phys. Condens. Matter 14 (2002) 10183-10191
> [4] S. Sen, D.R. Rhiger, C.R. Curtis, M.H. Kalisher, H.L. Hettich and M.C. Currie, "Infrared Absorption Behavior in CdZnTe Substrates", Journal of Electronic Materials, vol. 30, n°6, 2001

Le procédé précédemment décrit présente cependant de nombreux défauts et désavantages et entraîne plusieurs difficultés :

> 1. sa mise en oeuvre nécessite le contrôle de deux températures, à savoir une pour la source contenant l'élément II et une pour le matériau II-VI, et ces températures ne sont pas indépendantes ;
>
> 2. un asservissement des cinétiques de montée et de descente en température de la source et du matériau II-VI est nécessaire pour qu'à tout instant, la pression de l'élément II soit égale à la pression partielle de cet élément au-dessus du matériau II-VI ;

3. la détermination de la pression de l'élément II correspondant au point stoechiométrique doit être la plus précise possible, et ceci pour toutes les températures auxquelles le matériau II-VI est recuit ;

4. le contrôle de la pression de l'élément II pendant la phase de recuit est assuré par la précision du contrôle de la température de la source de l'élément II, de façon que $P_{II}=\bar{P}_{II}$ au-dessus du matériau II-VI stoechiométrique ;

5. sa réalisation n'est possible qu'en tube scellé, ce qui signifie qu'il faut consommer un tube de quartz par recuit.

Il ressort donc de ce qui précède que le procédé de recuit, dans lequel on applique une pression de l'élément II au-dessus du matériau II-VI est extrêmement complexe à mettre en oeuvre et surtout extrêmement difficile à reproduire de manière fiable, du fait notamment des réglages, mesures, contrôles, précis et sensibles qu'il implique.

Il existe donc un besoin pour un procédé d'élimination par recuit des précipités dans un matériau solide semi-conducteur II-VI qui soit simple, fiable, reproductible, facile à mettre en oeuvre, économique et qui assure une élimination totale des précipités.

Il existe encore un besoin pour un procédé d'élimination par recuit des précipités dans un matériau solide semi-conducteur II-VI, qui ne présente pas les inconvénients, défauts, limitations, désavantages, et difficultés des procédés de recuit de l'art antérieur et qui résolve les problèmes des procédés de l'art antérieur.

Le but de la présente invention est de fournir un procédé d'élimination par recuit des précipités dans un matériau solide semi-conducteur II-VI, tel que CdTe, CdZnTe ou ZnTe, qui réponde, entre autres, à ces besoins.

Ce but et d'autres encore sont atteints, conformément à l'invention selon la revendication 1, par un procédé d'élimination par recuit des précipités contenus dans un matériau semi-conducteur II-VI, dans lequel ledit matériau solide semi-conducteur est un matériau solide semi-conducteur à sublimation congruente, et dans lequel on effectue les étapes successives suivantes :

- on chauffe sous circulation de gaz neutre le matériau solide semi-conducteur jusqu'à une température T comprise entre une première température $T_1$, correspondant à l'eutectique composé II-VI/élément VI, et une seconde température $T_2$, correspondant à la température maximale de sublimation congruente ;
- on maintient sous circulation de gaz neutre le matériau solide à cette température T pendant une durée suffisante pour éliminer les précipités ;
- on refroidit le matériau solide semi-conducteur sous circulation de gaz neutre depuis la température T jusqu'à la température ambiante à une vitesse telle que le matériau solide se confonde au cours du refroidissement avec sa ligne de sublimation congruente ;
- on récupère le matériau solide semi-conducteur exempt de précipités.

Par température ambiante on entend une température généralement de 20 à 25°C par exemple de 21 à 24°C, notamment de 22 à 23°C.

Eventuellement, on pourrait exprimer que le chauffage sous circulation de gaz neutre et/ou le maintien sous circulation de gaz neutre et/ou le refroidissement peuvent se faire sans contrepression d'élément II et/ou d'élément VI. On comprend cependant bien que l'on emploie les termes « sans » contrepression il y a en fait toujours une certaine pression des éléments II et/ou VI inhérente à la sublimation. Mais on ne met en oeuvre aucune mesure pour établir une contrepression comme cela est le cas dans l'art antérieur. La seule pression est celle due naturellement, de manière inhérente à la sublimation sans que l'on ne fasse rien pour cela.

Le procédé selon l'invention n'a jamais été décrit dans l'art antérieur.

Le procédé selon l'invention ne présente pas les difficultés, défauts, limitations et désavantages des procédés de l'art antérieur et il résout les problèmes posés par les procédés de l'art antérieur, en particulier le procédé selon l'invention ne nécessite généralement au contraire des procédés de l'art antérieur aucune contre pression d'élément II ou VI. De ce fait, les mesures, régulations, liées à l'établissement de cette contre pression sont supprimées.

Le procédé selon l'invention est, entre autres, simple, fiable, facile à mettre en oeuvre, reproductible et économique.

Le procédé selon l'invention se distingue notamment fondamentalement des procédés de l'art antérieur tels que ceux décrits dans les documents US-A-5 201 985, US-A-4 190 486, US-A-4 481 044, EP-A-0 423 463, en ce que l'on opère sous circulation de gaz neutre. Le fait que le procédé selon l'invention se déroule sous balayage, circulation de gaz neutre, ou plus précisément que la surface de croissance du matériau soit sous balayage de gaz neutre change totalement, complétement, les conditions de croissance et de refroidissement du matériau et apporte de nombreux avantages par rapport aux procédé de l'art antérieur.

Une telle circulation de gaz neutre peut être réalisée avec un tube, réacteur, ouvert - réacteur dans lequel se trouve placé le matériau, généralement dans un creuset - par opposition aux tubes dits « fermés », « scellés » des procédés de l'art antérieur dans lesquels une circulation de gaz neutre est, de ce fait, impossible. Le fait d'opérer sous une circulation de gaz neutre est totalement différent du fait d'opérer sous une simple atmosphère de gaz neutre, stationnaire, sans mise en circulation, balayage.

L'intérêt d'opérer sous une circulation de gaz neutre est en particulier de permettre l'entraînement des vapeurs d'éléments II et VI tels que le tellure et le cadmium s'échappant, effusant, du matériau à recuire par exemple par l'orifice d'un creuset fonctionnant en cellule de Knudsen.

La circulation de gaz neutre crée ainsi une situation de quasi-équilibre dynamique au-dessus du matériau, par exemple dans le volume mort du creuset, moteur, en quelque sorte, de la sortie des inclusions et précipités, par exemple d'élément VI, tel que le tellure initialement présents dans le matériau, l'échantillon à recuire. Les vapeurs ainsi entraînées sont condensées au point froid du réacteur, tube, comme cela est décrit plus loin. Le débit de gaz neutre peut être facilement adapté par l'homme du métier, il peut être par exemple de 10 à 1000 cc/minute, de préférence, de 100 à 500 cc/minute sous une pression de 1 atmosphère.

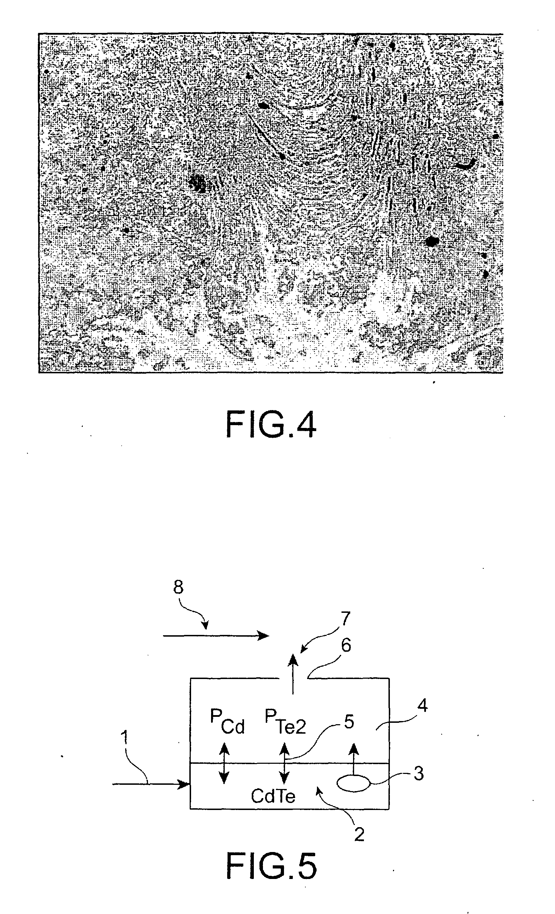

La situation de quasi-équilibre peut par exemple être schématisée comme cela est décrit sur la figure 5.

Au sein de la nacelle, du creuset, le quasi-équilibre est auto-adaptatif, notamment au cours du refroidissement, puisque les pressions partielles d'élément VI et d'élément II tels que le Cd et Te s'adaptent d'elles-mêmes à la nouvelle température afin de respecter la constante d'équilibre.

Il est évident que ceci ne peut se faire que dans notre configuration et grâce à la circulation de gaz neutre.

Dans l'art antérieur, l'expérimentateur doit accompagner la température de la source d'élément VI tel que le Cd (ou d'élément II tel que le Te) pour assurer cet équilibre, ce qui ne peut pas être fait avec une aussi parfaite précision que dans notre procédé.

C'est pourquoi, dans notre cas, l'échantillon, le matériau recuit suit parfaitement, se confond avec sa ligne de sublimation congruente au cours du refroidissement et que cette démarche est parfaitement reproductible d'une expérience à l'autre, alors qu'il ne s'agit que d'une approche d'un rapprochement, d'un suivi à distance de cette ligne, qui plus est, non reproductible, dans le cas des procédés de l'art antérieur qui mettent en oeuvre un tube fermé.

Selon l'invention, on a trouvé dans le diagramme d'équilibre de phases la solution à l'élimination des précipités qui sont des défauts thermodynamiques.

On peut dire que, selon l'invention, et connaissant le diagramme de phases du matériau II-VI, on fait en sorte de maintenir le composé II-VI dans son domaine d'existence où la précipitation ne peut avoir lieu. On utilise à ces fins la ligne de sublimation congruente en se confondant avec cette ligne, en suivant parfaitement, exactement, celle-ci, pour conduire le recuit. Une telle démarche est inattendue et n'a jamais été suggérée dans l'art antérieur.

De manière fondamentale, selon l'invention, on ne s'approche pas de la ligne de sublimation congruente, on ne la suit pas à distance, mais l'on se confond parfaitement avec celle-ci, on la suit exactement. La manière d'utiliser la ligne de sublimation congruente conformément à l'invention garantit à coup sûr d'être parfaitement sur cette ligne, et ce pendant le temps du recuit mais aussi et surtout pendant le retour à la température ambiante, comme on l'a déjà expliqué plus haut.

L'assurance, la garantie de se trouver exactement, de manière certaine, à chaque fois sur la ligne de sublimation congruente est liée à la circulation de gaz neutre et au quasi-équilibre auto-adaptatif qui s'établit selon l'invention.

Dans les procédés de l'art antérieur sans circulation de gaz neutre, on s'approche seulement de la ligne de sublimation congruente sans parvenir à se confondre avec celle-ci. Et cette simple approche est aléatoire, non reproductible. Le procédé selon l'invention est donc nettement plus fiable que ceux de l'art antérieur.

Avantageusement, la première température $T_1$ est, dans le diagramme de phase du matériau semi-conducteur II-VI, la température correspondant à l'intersection de la verticale passant par le point de fusion maximal du matériau (c'est le point le plus haut du solidus) et le solidus.

Avantageusement, la seconde température $T_2$ est, dans le diagramme de phase du matériau semi-conducteur II-VI, la température correspondant à l'intersection de la ligne de sublimation congruente et du solidus.

Les précipités sont généralement des précipités de l'élément VI.

Avantageusement, le matériau semi-conducteur II-VI est choisi parmi CdTe, $Cd_{1-x}Zn_xTe$ où x va de 0 à 1, et ZnTe.

Ce type de matériaux ne contient généralement en tant que précipités, que des précipités de Tellure.

Si le matériau est du CdTe, les précipités étant constitués uniquement de Tellure, la première température $T_1$ est de 830°C et la seconde température $T_2$ est de 1 040°C.

Si le matériau est du ZnTe, les précipités étant constitués uniquement de tellure, la première température $T_1$ est de 820°C et la seconde température $T_2$ est de 1240°C.

Avantageusement, la durée pendant laquelle le matériau solide est maintenu à la température T constante, unique, cette durée pouvant aussi être appelée "durée de recuit", est de 1 minute à 50 heures.

Cette durée de maintien à la température T unique, ou durée du recuit, dépend du volume du matériau soumis au procédé et de la température choisie.

A titre d'exemple, dans le cas d'un substrat de CdZnTe, porté à 1 040°C, une durée du recuit de 5 minutes suffit à purger le substrat de la deuxième phase (à savoir des précipités de Te) qu'il contenait, comme le montre les figures jointes. Un des avantages du procédé de l'invention est que le recuit est réalisé à une température unique, constante, sans profil de température et régulation de températures complexes.

Le matériau semi-conducteur II-VI traité par le procédé selon l'invention peut se présenter sous une grande variété de formes, il peut notamment se présenter sous la forme d'un substrat unique ou de plusieurs substrats, chacun de ces substrats pouvant se présenter sous la forme d'un bloc ou lingot.

Le gaz neutre est généralement choisi parmi l'argon, et l'hélium.

Le matériau solide semi-conducteur II-VI peut être un matériau élaboré par une méthode BRIDGMAN au point de fusion maximum ou en solvant d'élément VI, tel que le Te.

Avantageusement, le matériau est placé dans un creuset conçu comme une cellule de KNUDSEN.

Avantageusement, le procédé est réalisé dans un tube, réacteur, ouvert qui permet une circulation, balayage de gaz neutre.

L'invention va maintenant être décrite, notamment en relation avec des exemples de réalisation particulier dans la description détaillée qui va suivre, donnée à titre illustratif et non limitatif et en relation avec les dessins joints dans lesquels :

- la figure 1 est le diagramme de phase de CdTe. En ordonnée, est portée la température (en K) et en abscisse est portée la fraction atomique de tellure ;
- la figure 2A est une photographie réalisée en transmission IR, à l'aide d'un microscope IR, qui montre la "cartographie" d'un substrat de CdTe brut de croissance ("as grown" en anglais) issu d'un lingot réalisé à partir d'un liquide de composition proche de celle du point de fusion maximal ;
- la figure 2B est une photographie réalisée en transmission IR, à l'aide d'un microscope IR, qui montre la "cartographie" du même substrat que celui de la figure 2A, mais après recuit, conformément au procédé selon l'invention ;
- la figure 3A représente un champ observé à un plus fort grossissement ("zoomé") de la photographie de la figure 2A (avant la mise en oeuvre de l'invention) ;
- la figure 3B représente le champ observé de la photographie de la figure 3A (après la mise en oeuvre de l'invention) ;
- la figure 4 est une image prise au microscope optique (grossissement 200) d'une tranche de ZnTe, exempte de seconde phase de précipité, après un recuit selon le procédé de l'invention ;
- la figure 5 est une vue en coupe schématique d'un dispositif pour la mise en oeuvre du procédé selon l'invention et illustre le principe de ce procédé.

Le principe à la base de l'invention, qui est basé essentiellement sur le diagramme d'équilibre des phases du matériau solide semi-conducteur, est illustré sur la figure 1.

La figure 1 concerne le CdTe, mais il est bien évident que les explications et commentaires relatifs à cette figure peuvent être aisément transposés par l'homme du métier aux autres matériaux semi-conducteurs II-VI à sublimation congruente.

Supposons donc un solide CdTe élaboré au point de fusion maximum ou en solvant Tellure et ne contenant que des précipités de Tellure. Remontons ce solide à une température comprise entre 830 et 1 040°C : sur le diagramme joint (figure 1), 830°C (= 1 100 K) correspond à la température à laquelle un CdTe réalisé près du point de fusion maximum commence à générer des précipités au cours de son refroidissement, et 1 040°C est la température du solidus à laquelle la ligne de sublimation congruente intercepte le solidus.

Si ce lingot, porté à une température incluse entre ces deux limites, est placé dans un tube ouvert dans lequel circule un gaz neutre, tel que Ar, sans aucune contre-pression de Cd ou de Te, alors, quelque soit son écart initial à la stoechiométrie, sa composition va évoluer, à température constante, de façon à venir se caler sur la ligne de sublimation congruente : dans son domaine d'existence, le solide ne contient aucun précipité ; il ne suffit plus alors que de refroidir ce solide à une vitesse suffisamment lente pour qu'à chaque instant, il s'équilibre avec sa vapeur et se confonde, au cours du refroidissement, avec la ligne de sublimation congruente. Cette ligne, étant incluse dans le domaine d'équilibre, ne traverse jamais la ligne solidus et permet de récupérer, à la température ambiante, un solide exempt de précipités.

Supposons cette fois un solide ZnTe élaboré en tube de quartz scellé par la méthode BRIDGMAN en solvant Tellure, et ne contenant que des précipités de Tellure. Ce solide, remonté à une température inférieure à la température de l'intersection de la ligne de sublimation congruente avec le solidus (1240°C), va évoluer conformément au procédé selon l'invention, de façon à se caler sur la ligne de sublimation congruente : dans son domaine d'existence, le solide ne contient aucun précipité ; il ne suffit plus alors que de refroidir ce solide à une vitesse suffisamment lente pour qu'à chaque instant, il s'équilibre avec sa vapeur et se confonde, au cours du refroidissement, avec sa ligne de sublimation congruente.

De nouveau, on récupère ainsi à la température ambiante un solide exempt de précipités de Tellure (voir figure 4).

Le procédé selon l'invention peut être mis en oeuvre, par exemple, de la manière suivante comme cela est décrit sur la figure 5 :

Dans un tube de quartz fermé à une extrémité et dont l'autre extrémité est obturable par un flasque étanche, on place un creuset (1) contenant le matériau semi-conducteur II-VI (2). Ce matériau (2) peut être, par exemple, soit un substrat monocristallin, par exemple de CdTe (ou de CdZnTe), soit un bloc constitué d'un seul grain extrait d'un lingot polycristallin, par exemple de CdTe (ou CdZnTe), soit un lingot monocristallin, par exemple de CdTe (ou CdZnTe) ; la forme et les dimensions de ce creuset sont adaptées à la forme et aux dimensions de l'échantillon à recuire.

Le matériau II-VI tel que du CdTe peut comprendre des inclusions (3) par exemple d'élément VI tel que du Te. Sur la figure 5, on a indiqué à titre d'exemple que le matériau dans le creuset est du CdTe avec des inclusions de Te.

La matière constituant le creuset (1) est, de préférence, facile à usiner et doit présenter une conductivité thermique favorisant l'isothermicité, le graphite, par exemple, peut parfaitement convenir. Le creuset est conçu de manière à recevoir l'échantillon et à ménager, au-dessus de celui-ci, un volume mort (4) suffisant pour assurer, pendant l'étape de recuit, un pseudo-équilibre (représenté par les doubles flèches 5) entre le solide à recuire et sa phase vapeur (pressions PCd et PTe) ; le creuset (1) est fermé par un bouchon réalisé dans la même matière que le corps du creuset ; ce bouchon porte un orifice calibré (6) permettant à l'ensemble de fonctionner comme une cellule de KNUDSEN. C'est par cet orifice (6) que l'élément le plus volatil constitutif du matériau II-VI va s'évaporer prioritairement (flèche 7).

Pendant l'étape de recuit selon l'invention, le tube de quartz contenant creuset et échantillon est introduit dans un four et porté à la température de recuit ; son extrémité fermée par le flasque à l'extérieur du four reste à la température ambiante et crée un point froid, où la vapeur s'échappant du creuset et entraînée par la circulation de gaz neutre tel que de l'argon (8) vient se condenser.

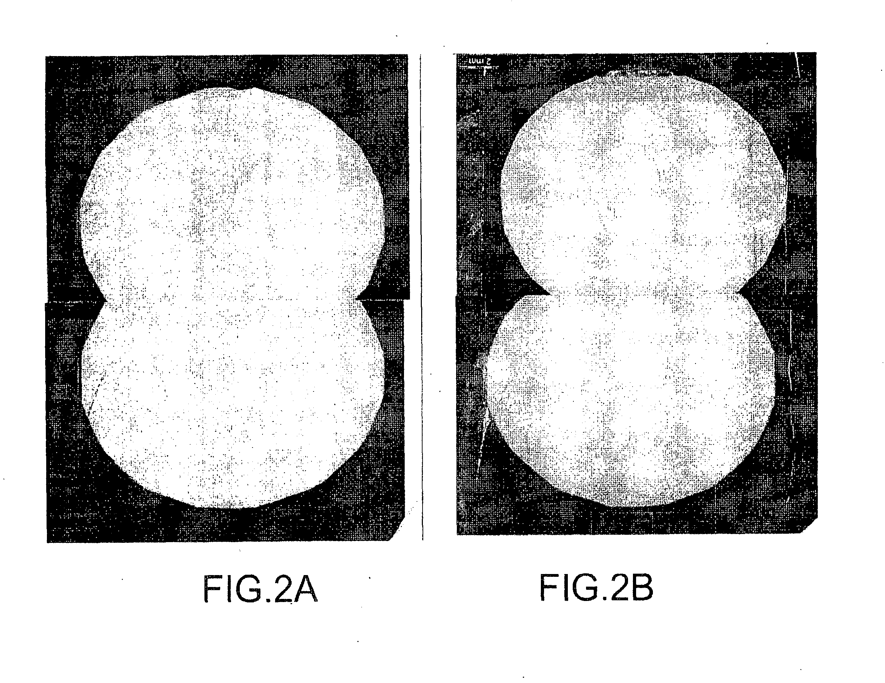

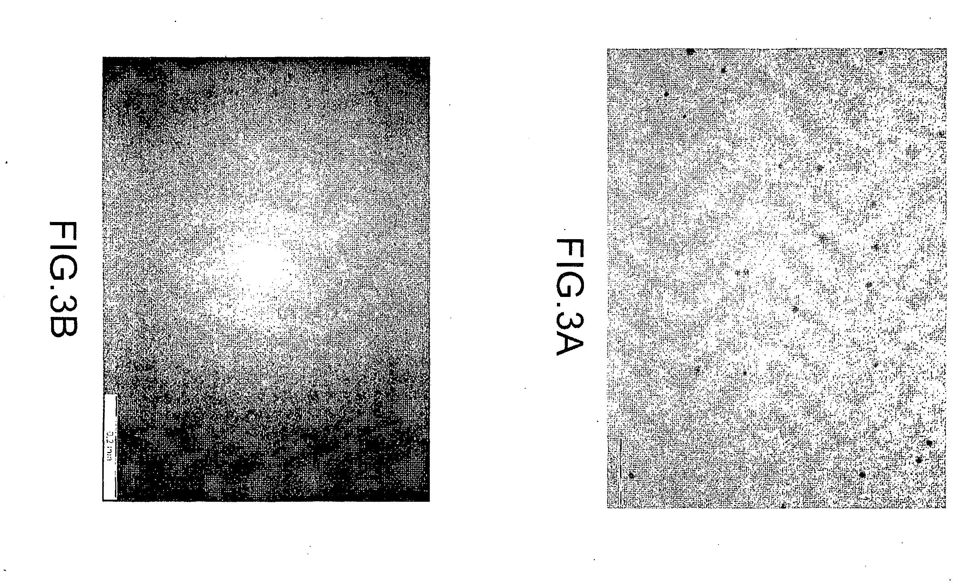

Comme on l'a déjà indiqué, la durée du recuit dépend du volume de l'échantillon à recuire et de la température choisie ; dans le cas d'un substrat de CdZnTe par exemple, porté à 1 040˚C, une durée de 5 minutes suffit à purger ce substrat de la deuxième phase qu'il contenait, comme le montrent les figures 2B et 3B.

Au cours d'un recuit selon le procédé de l'invention, l'échantillon à recuire perd de la matière :

• les précipités et inclusions, par exemple de tellure, dans le cas de CdTe, qui ne pèsent pas lourds,

• les atomes de cadmium et de tellure constitutifs du réseau cristallin (dans le cas de CdTe) qui s'évaporent pour établir les pressions partielles d'équilibre dans le volume mort du creuset, et pour les maintenir au cours du temps, compte tenu de leur fuite par l'orifice.

L'ordre de grandeur estimé de ces pertes est par exemple pour un échantillon initial de 5 grammes, 1 gramme de matière Cd et Te perdu pour quelques centaines de microgrammes de précipités et inclusions.

Cette perte de matière dégrade l'aspect de surface initialement poli, et, après recuit, un très léger repolissage rétablit l'aspect initial.

L'invention va maintenant être décrite, en référence aux exemples suivants, donnés à titre illustratif et non limitatif.

<u>Exemple 1</u>

Dans cet exemple, on élimine les précipités de Tellure d'un matériau solide semi-conducteur par le procédé selon l'invention.

Le matériau de départ est un solide de CdTe élaboré au point de fusion maximum.

Le substrat monocristallin de dimensions 36 par 38 mm$^2$ et d'épaisseur 750 $\mu$m est orienté selon l'axe [111]. Ses surfaces sont polies optiques selon la procédure habituelle ; elles sont ensuite décapées dans une solution de méthanol contenant 5% de brome, juste avant que le substrat ne soit chargé dans le creuset de graphite adapté. Ce dernier est alors fermé par un couvercle muni d'un trou calibré (diamètre 2 mm). Ce creuset semi-clos est introduit dans le réacteur de recuit, constitué d'un tube de quartz dont l'ouverture est obturée par un flasque étanche.

Un thermocouple est positionné au plus près du substrat dans le creuset de graphite. Le réacteur de quartz est alors mis en vide, puis rempli d'argon à la pression de 1 atmosphère. Le réacteur est, par la suite, maintenu sous balayage d'argon au débit de 100 cc/minute sous la pression de 1 atmosphère.

Le four dans lequel le tube de quartz est installé, est alors mis en chauffe et suit un programme thermique imposé par l'expérimentateur pour atteindre la température de 1040˚C, à la vitesse de 250˚C/heure. Il reste à cette température pendant 5 minutes, avant de revenir à la température ambiante à la vitesse de 40˚C/heure.

A la température ambiante, le substrat d'épitaxie est sorti du creuset et est caractérisé par microscopie IR à transmission, après un léger polissage rendu nécessaire suite à l'évaporation subie pendant la phase de recuit.

Sur la figure 2A, qui présente la "cartographie", réalisée par transmission IR à l'aide d'un microscope, du substrat brut de croissance ("as grown" en anglais), on constate que les champs de cette cartographie présentent des points noirs caractéristiques de la présence d'une seconde phase.

Un champ observé à un plus fort grossissement (figure 3A) montre précisément la forme, la taille et la répartition de ces points noirs de la seconde phase.

La figure 2B montre la cartographie du même substrat après recuit selon le procédé de l'invention, cartographie réalisée avec un microscope infrarouge à transmission. On n'observe plus de points noirs correspondant à une seconde phase à la température ambiante. Cela est confirmé par la photographie réalisée à un plus fort grossissement (figure 3B).

<u>Exemple 2</u>

Dans cet exemple, on réalise la même expérience que dans l'exemple 1 (avec les mêmes conditions) avec un substrat monocristallin de $Cd_xZn_{1-x}Te$ avec x = 0,4 : les mêmes résultats ont été obtenus.

Exemple 3

Dans cet exemple, on élimine les précipités d'un solide ZnTe élaboré en tube de quartz scellé par la méthode BRIDGMAN en solvant Tellure et ne contenant que des précipités de Tellure.

Un substrat monocristallin d'orientation [111] de dimensions 10 par 10 $mm^2$ et d'épaisseur 350 $\mu m$ est traité de la même façon que le CdTe précédent ; il est introduit dans un creuset en graphite semblable à celui utilisé pour le CdTe, lequel est positionné dans le réacteur balayé par le flux d'argon avec un débit de 100 cc/minute, sous la pression de 1 atmosphère.

Afin de tenir compte du diagramme spécifique du ZnTe, la température de recuit peut être choisie dans la gamme de 449,5˚C à 1240˚C (température maximale d'évaporation congruente ou température à laquelle la ligne d'évaporation congruente intercepte le solidus), selon l'invention.

Pour ce recuit, elle est de 1010˚C pendant 5 minutes. Le retour à la température ambiante se fait à la vitesse de 40˚C/heure.

L'observation au microscope visible peut se faire directement en transmission, le ZnTe étant transparent à ces longueurs d'onde et sa surface s'étent peu dégradée lors de la phase de recuit.

La figure 4 montre une image en transmission prise au microscope optique (grossissement 200) d'une tranche de ZnTe exempt de seconde phase après un recuit selon le procédé de l'invention.

**Revendications**

1.  Procédé d'élimination par recuit des précipités contenus dans un matériau solide de semi-conducteur II-VI, dans lequel ledit matériau solide semi-conducteur est un matériau solide semi-conducteur à sublimation congruente, et dans lequel on effectue les étapes successives suivantes :

    - on chauffe sous circulation de gaz neutre le matériau solide semi-conducteur jusqu'à une température T comprise entre une première température $T_1$, correspondant à l'eutectique composé II-VI/élément VI, et une seconde température $T_2$, correspondant à la température maximale de sublimation congruente ;
    - on maintient sous circulation de gaz neutre le matériau solide à cette température T pendant une durée suffisante pour éliminer les précipités ;
    - on refroidit le matériau solide semi-conducteur sous circulation de gaz neutre depuis la température T jusqu'à la température ambiante à une vitesse telle que le matériau solide se confonde au cours du refroidissement avec sa ligne de sublimation congruente ;
    - on récupère le matériau solide semi-conducteur exempt de précipités.

2.  Procédé selon la revendication 1, dans lequel la première température $T_1$ est, dans le diagramme de phase du matériau semi conducteur II-VI, la température correspondant à l'intersection de la verticale passant par le point de fusion maximal du matériau et le solidus.

3.  Procédé selon l'une quelconque des revendications précédentes, dans lequel la seconde température $T_2$ est, dans le diagramme de phase du matériau semi-conducteur II-VI, la température correspondant à l'intersection de la ligne de sublimation congruente et du solidus.

4.  Procédé selon l'une quelconque des revendications précédentes, dans lequel les précipités sont des précipités de l'élément VI.

5.  Procédé selon l'une quelconque des revendications précédentes, dans lequel le matériau semi-conducteur II-VI est choisi parmi CdTe, $Cd_{1-x}Zn_xTe$ où x va de 0 à 1 et ZnTe.

6.  Procédé selon la revendication 5, dans lequel le matériau semi-conducteur II-VI ne contient, en tant que précipités, que des précipités de Tellure.

7.  Procédé selon l'une quelconque des revendications précédentes, dans lequel le matériau semi-conducteur est du CdTe, les précipités sont constitués uniquement de Tellure, la première température $T_1$ est de 830˚C et la seconde température $T_2$ est de 1 040˚C.

8.  Procédé selon l'une quelconque des revendications 1 à 6, dans lequel le matériau semiconducteur est du ZnTe, les précipités sont constitués uniquement de tellure, la première température $T_1$ est de 820˚C et la seconde température $T_2$ est de 1240˚C.

9.  Procédé selon l'une quelconque des revendications précédentes, dans lequel la température T est maintenu pendant une durée de 1 mn à 50 heures.

10. Procédé selon l'une quelconque des revendications précédentes, dans lequel le matériau se présente sous la forme d'un substrat unique ou de plusieurs substrats, chacun de ces substrats étant sous la forme d'un bloc ou lingot.

11. Procédé selon l'une quelconque des revendications précédentes, dans lequel le gaz inerte est choisi parmi l'argon et l'hélium.

**12.** Procédé selon l'une quelconque des revendications précédentes, dans lequel le matériau solide semiconducteur est un matériau élaboré par une méthode BRIDGMAN au point de fusion maximum, ou en solvant d'élément VI.

**13.** Procédé selon l'une quelconque des revendications précédentes, dans lequel le matériau est placé dans un creuset conçu comme une cellule de KNUDSEN.

**14.** Procédé selon l'une quelconque des revendications précédentes, dans lequel le procédé est réalisé dans un tube, réacteur, ouvert.

**Claims**

**1.** Method for eliminating the precipitates contained in an II-VI solid semiconductor material by annealing, in which said solid semiconductor material is a congruent sublimation solid semiconductor material, and in which the following successive steps are carried out:

 - the solid semiconductor material is heated under an inert gas flow up to a temperature T, comprised between a first temperature $T_1$, corresponding to the compound II-VI/element VI eutectic, and a second temperature $T_2$, corresponding to the maximum congruent sublimation temperature;
 - the solid material is held at this temperature T under a neutral gas flow for a time period sufficient to eliminate the precipitates;
 - the solid semiconductor material is cooled under an inert gas flow from temperature T to ambient temperature, at a rate such that, during cooling, the solid material merges with its congruent sublimation line;
 - the precipitate-free solid semiconductor material is recovered.

**2.** Method according to claim 1, in which, in the phase diagram for the II-VI semiconductor material, the first temperature $T_1$ is the temperature corresponding to the intersection of the vertical passing through the maximum melting point of the material and the solidus.

**3.** Method according to any one of the preceding claims, in which, in the phase diagram for the II-VI semiconductor material, the second temperature $T_2$ is the temperature corresponding to the intersection of the congruent sublimation line and the solidus.

**4.** Method according to any one of the preceding claims, in which the precipitates are precipitates of element VI.

**5.** Method according to any one of the preceding claims, in which the II-VI semiconductor material is chosen from amongst CdTe, $Cd_{1-x}2n_xTe$ where x ranges from 0 to 1, and ZnTe.

**6.** Method according to claim 5, in which, as precipitates, the II-VI semiconductor material contains only tellurium precipitates.

**7.** Method according to any one of the preceding claims, in which the semiconductor material is CdTe, the precipitates consist solely of tellurium, the first temperature $T_1$ is 830°C and the second temperature $T_2$ is 1040°C.

**8.** Method according to any one of claims 1 to 6, in which the semiconductor material is ZnTe, the precipitates consist solely of tellurium, the first temperature $T_1$ is 820°C and the second temperature $T_2$ is 1240°C.

**9.** Method according to any one of the preceding claims, in which the temperature T is maintained for a time period of 1 min to 50 hours.

**10.** Method according to any one of the preceding claims, in which the material is in the form of a single substrate or several substrates, each of these substrates being in the form of a block or ingot.

**11.** Method according to any one of the preceding claims, in which the inert gas is chosen from amongst argon and helium.

**12.** Method according to any one of the preceding claims, in which the solid semiconductor material is a material fabricated by a Bridgman method at the maximum melting point, or in an element VI solvent.

**13.** Method according to any one of the preceding claims, in which the material is placed inside a crucible designed like a Knudsen cell.

**14.** Material according to any one of the preceding claims, in which the method is carried out in an open reactor, tube.

**Patentansprüche**

**1.** Verfahren zur Eliminierung der in einem festen II-VI-Halbleitermaterial enthaltenen Ausscheidungen durch Glühen, bei dem das feste Halbleitermaterial ein festes Halbleitermaterial mit kongruenter Sublimation ist, und bei dem man die folgenden sukzessiven Schritte durchführt:

- man erhitzt das feste Halbleitermaterial unter Zirkulation von neutralem Gas bis auf eine Temperatur T, enthalten zwischen einer dem Eutektikum 11-VI-Verbindung/VI-Element entsprechenden ersten Temperatur $T_1$ und einer der maximalen Temperatur kongruenter Sublimation entsprechenden zweiten Temperatur $T_2$;
- man hält das feste Material unter Zirkulation von neutralem Gas ausreichend lang auf dieser Temperatur T, um die Ausscheidungen zu eliminieren;
- man kühlt das feste Material unter Zirkulation von neutralem Gas von der Temperatur T bis auf die Umgebungstemperatur mit einer solchen Geschwindigkeit ab, dass das feste Material im Laufe der Abkühlung genau seiner Linie der kongruenten Sublimation folgt;
- man gewinnt das von Ausscheidungen befreite feste Halbleitermaterial.

2. Verfahren nach Anspruch 1, bei dem die erste Temperatur $T_1$ in dem Phasendiagramm des II-VI-Halbleitermaterials die dem Schnittpunkt der durch den maximalen Schmelzpunkt des Materials verlaufenden Vertikalen und der Soliduslinie entsprechende Temperatur ist.

3. Verfahren nach einem der vorangehenden Ansprüche, bei dem die zweite Temperatur $T_2$ in dem Phasendiagramm des II-VI-Halbleitermaterials die dem Schnittpunkt der Linie der kongruenten Sublimation und der Soliduslinie entsprechende Temperatur ist.

4. Verfahren nach einem der vorangehenden Ansprüche, bei dem die Ausscheidungen Ausscheidungen des VI-Elements sind.

5. Verfahren nach einem der vorangehenden Ansprüche, bei dem das II-VI-Halbleitermaterial ausgewählt wird unter CdTe, $Cd_{1-x}Zn_xTe$, wo x von 0 bis 1 geht, und ZnTe.

6. Verfahren nach Anspruch 5, bei dem das II-VI-Halbleitermaterial als Ausscheidungen nur Tellurausscheidungen enthält.

7. Verfahren nach einem der vorangehenden Ansprüche, bei dem das Halbleitermaterial CdTe ist, die Ausscheidungen nur durch Tellur gebildet werden, die erste Temperatur $T_1$ 830˚C und die zweite Temperatur $T_2$ 1 040˚C beträgt.

8. Verfahren nach einem der Ansprüche 1 bis 6, bei dem das Halbleitermaterial ZnTe ist, die Ausscheidungen nur durch Tellur gebildet werden, die erste

Temperatur $T_1$ 820˚C und die zweite Temperatur $T_2$ 1 240˚C beträgt.

9. Verfahren nach einem der vorangehenden Ansprüche, bei dem die Temperatur T während einer Dauer von 1 Minute bis 50 Stunden aufrechterhalten wird.

10. Verfahren nach einem der vorangehenden Ansprüche, bei dem das Material ein einziges Substrat oder mehrere Substrate umfasst, wobei jedes dieser Substrate die Form eines Blocks oder Barrens aufweist.

11. Verfahren nach einem der vorangehenden Ansprüche, bei dem das inerte Gas ausgewählt wird unter Argon und Helium.

12. Verfahren nach einem der vorangehenden Ansprüche, bei dem das feste Halbleitermaterial ein durch ein BRIDGMAN-Verfahren am maximalen Schmelzpunkt oder aus VI-Element-Überschussschmelze hergestelltes Material ist.

13. Verfahren nach einem der vorangehenden Ansprüche, bei dem das Material in einen wie eine KNUDSEN-Zelle konzipierten Tiegel gegeben wird.

14. Verfahren nach einem der vorangehenden Ansprüche, bei dem das Verfahren in einem offenen Rohr, Reaktor realisiert wird.

FIG.1

FIG.2B

FIG.2A

FIG.3A

FIG.3B

FIG.4

FIG.5

## RÉFÉRENCES CITÉES DANS LA DESCRIPTION

**Documents brevets cités dans la description**

- US 6299680 B
- US 5201985 A
- US 4190486 A
- US 4481044 A
- EP 0423463 A

**Littérature non-brevet citée dans la description**

- **H.R. VYDYANATH ; J.A. ELLSWORTH ; J.B. PARKINSON.** Thermomigration of Te Precipitates and Improvement of (Cd, Zn)Te Substrate Characteristics for the Fabrication of LWIR (Hg,CD)Te Photodiodes. *Journal of Electronics Materials,* 1993, vol. 22
- **LI YUJIE ; JIE WANQI.** Reduction of Te-rich phases in Cd1-xZnxTe (x=0.04) crystals. *J. Phys. Condens. Matter,* 2002, vol. 14, 10183-10191
- **S. SEN ; D.R. RHIGER ; C.R. CURTIS ; M.H. KALISHER ; H.L. HETTICH ; M.C. CURRIE.** Infrared Absorption Behavior in CdZnTe Substrates. *Journal of Electronic Materials,* 2001, vol. 30 (6